# EUROPÄISCHE PATENTSCHRIFT

(11) **EP 3 259 801 B1**
(45) Veröffentlichungstag und Bekanntmachung des Hinweises auf die Patenterteilung: **29.09.2021**
(21) Anmeldenummer: 16701264.0
(22) Anmeldetag: 15.01.2016
(51) Int. Cl.: H01P 5/02, H05K 1/02, H05K 1/14

(54) **VORRICHTUNG UND VERFAHREN ZUM ÜBERTRAGEN EINES HOCHFREQUENZSIGNALS**
DEVICE AND METHOD FOR TRANSMITTING A HIGH-FREQUENCY SIGNAL
DISPOSITIF ET PROCÉDÉ DE TRANSMISSION D'UN SIGNAL HAUTE FRÉQUENCE

(30) Priorität: 18.02.2015 DE 102015202872
(43) Veröffentlichungstag der Anmeldung: 27.12.2017
(73) Patentinhaber: Robert Bosch GmbH, 70442 Stuttgart (DE)
(72) Erfinder: PANCERA, Elena, 71229 Leonberg (DE); HASCH, Juergen, 70195 Stuttgart (DE)
(86) Internationale Anmeldenummer: PCT/EP2016/050779
(87) Internationale Veröffentlichungsnummer: WO 2016/131572

(56) Entgegenhaltungen:
- JP-A- 2008 193 243
- US-A1- 2008 297 283
- US-A1- 2011 050 534
- US-A1- 2013 278 349
- US-B1- 6 545 572

## Beschreibung

Die vorliegende Erfindung betrifft eine Vorrichtung und ein Verfahren zum Übertragen eines Hochfrequenzsignals.

### Stand der Technik

Hochfrequenzsignale werden häufig von an Leiterplatten ausgebildeten Antenneneinrichtungen mit Antennenelementen, etwa Mikrostreifenantennen, in Form von elektro-magnetischen Wellen ausgesendet. Üblicherweise ist eine möglichst große Fläche der Antenneneinrichtung, relativ zu der Fläche der Leiterplatte erwünscht, um den durch die Leiterplatte eingenommenen Raum optimal zu nutzen.

Herkömmlicherweise werden Mittel zum Erzeugen des Hochfrequenzsignals und die Antenneneinrichtung mit den Antennenelementen an derselben Oberfläche eines Trägers oder einer Leiterplatte ausgebildet. Dabei wird jedoch Platz auf der Oberfläche des Trägers oder der Leiterplatte verbraucht, welcher auch zum Ausbilden einer Antenneneinrichtung mit größerer Fläche verwendet werden könnte. Weiterhin können von den Mitteln zum Erzeugen des Hochfrequenzsignals und den galvanischen Verbindungen zu den Antennenelementen Störsignale ausgehen, welche die Qualität des auszusendenden Hochfrequenzsignals beeinträchtigen können.

Verschiedene Einkoppelvorrichtungen für elektromagnetische Strahlung sind aus den Druckschriften US 2013/0278349 A1, US 2011/0050534 A1 und US 2008/0297283 A1 bekannt.

In der DE 101 04 864 A1 ist eine Vorrichtung zum Senden und/oder Empfangen von Radarstrahlen beschrieben, welche eine Leiterplatte aufweist, auf deren einer Seite mindestens eine Antenne und auf deren anderer Seite elektrische Schaltkreise angeordnet sind. Über ein in Koplanar-Leitungstechnik ausgeführtes Speisenetzwerk ist die mindestens eine Antenne galvanisch mit den elektrischen Schaltkreisen verbunden.

### Offenbarung der Erfindung

Die vorliegende Erfindung offenbart eine Vorrichtung mit den Merkmalen des Patentanspruchs 1 und ein Verfahren mit den Merkmalen des Patentanspruchs 10.

Der elektrisch nichtleitende Träger kann auch als eine Vielschicht-Struktur ("multilayer") aus einer Vielzahl von Einzelschichten ausgebildet sein, wobei eine oder mehrere der Einzelschichten (partiell) elektrisch leitend sein kann bzw. können (z.B. ground, verdrahtete Leitungen...). Der Träger kann auch als Einzelschicht-Struktur realisiert sein.

### Vorteile der Erfindung

Die erfindungsgemäße Vorrichtung ermöglicht das Übertragen eines Hochfrequenzsignals durch einen Träger hindurch, wobei Verluste und unerwünschte Störsignale verringert oder vermieden werden und eine platzsparende Bauweise ermöglicht ist. Die Vorrichtung kann beispielsweise in einem Radarsystem verwendet werden.

Das Sende- und/oder das Empfangselement können beispielsweise als Mikrostreifen-Patch (engl.: "microstrip patch"), als koplanarer Wellenleiter-Patch (engl. "coplanar waveguide patch"), als aperturgekoppelter Patch (engl. "aperture coupled patch") oder als Dipol- oder Schlitzdipol (engl. "slot dipole") oder ein sonstiges Schlitzelement ausgebildet sein.

Der Durchgang fungiert z.B. als Kavität und kann beispielsweise metallisiert sein.

Die Abmessungen des Durchgangs begründen einen unteren Cutoff für die Frequenzen des Hochfrequenzsignals. Der Durchgang kann zylinderförmig sein und beispielsweise durch einen Ätzvorgang hergestellt werden. Der zylinderförmige Durchgang ist vorteilhaft mit einem Durchmesser von zwischen zwei und zehn Millimetern, bevorzugt zwischen drei und sechseinhalb Millimetern, ausgebildet, beispielsweise um ein Hochfrequenzsignal mit 77 Gigahertz zu übertragen. Vorteilhaft kann ein Hochfrequenzsignal mit einer Frequenz von mindestens zwanzig Gigahertz übertragen werden. Eine Bandbreite des Übertragens mittels der erfindungsgemäßen Vorrichtung wird durch Merkmale des Sende- und des Empfangselements beeinflusst.

Vorteilhafte Ausführungsformen und Weiterbildungen ergeben sich aus den Unteransprüchen sowie aus der Beschreibung unter Bezugnahme auf die Figuren.

Das Sendeelement ist zwischen dem Träger und einem ersten Reflektorelement angeordnet, welches aus der Richtung des Durchgangs einfallende elektromagnetische Wellen in Richtung des Durchgangs reflektiert. Gemäß einer weiteren Ausführungsform ist das Empfangselement zwischen dem Träger und einem zweiten Reflektorelement angeordnet, welches aus der Richtung des Durchgangs einfallende elektromagnetische Wellen in Richtung des Durchgangs reflektiert.

Gemäß einer weiteren Ausführungsform umfasst die Vorrichtung ein erstes Verschlusselement, welches an der ersten Oberfläche des Trägers über dem Durchgang angeordnet ist und welches eine erste metallische Schicht aufweist, welche dem Durchgang zugewandt ist. Gemäß einer weiteren Ausführungsform umfasst die Vorrichtung ein zweites Verschlusselement, welches an der zweiten Oberfläche des Trägers über dem Durchgang angeordnet ist und welches eine zweite metallische Schicht aufweist, welche dem Durchgang zugewandt ist. Das erste und das zweite Verschlusselement können vorteilhafterweise spiegelsymmetrisch bezüglich einer Spiegelsymmetrieebene ausgebildet sein. Die Verschlusselemente können einen weiteren Bestandteil der durch den Durchgang definierten Kavität bilden.

Gemäß einer Ausführungsform ist das erste Reflektorelement als eine an einer von dem Träger abgewandten Oberfläche des ersten Verschlusselements angebrachte dritte metallische Schicht ausgebildet. Gemäß einer Ausführungsform ist das zweite Reflektorelement als eine an einer von dem Träger abgewandten Oberfläche des zweiten Verschlusselements angebrachte vierte metallische Schicht ausgebildet. Somit ist durch das oder die Reflektorelemente eine besonders hohe Reflektivität für die elektromagnetischen Wellen, beispielsweise von über 50%, bevorzugt von über 75 %, besonders bevorzugt von über 90 %, ganz besonders bevorzugt von über 99% erreichbar.

Soll ein erstes Element "auf" einer Oberfläche eines zweiten Elements ausgebildet werden, so soll darunter sowohl verstanden sein, dass es unmittelbar an dem zweiten Element an der Oberfläche ausgebildet wird, als auch, dass es mittelbar über dieser Oberfläche ausgebildet wird. Soll das erste Element "an" der Oberfläche des zweiten Elements ausgebildet werden, ist darunter zu verstehen, dass es unmittelbar an der Oberfläche ausgebildet wird. Soll das erste Element in Bezug auf ein zweites Element auf eine bestimmte Weise angeordnet werden, soll damit nicht notwendigerweise bestimmt sein, dass das zweite Element schon ausgebildet sein muss, wenn das erste Element ausgebildet wird.

Vielmehr wird hier ein Endzustand beschrieben, welchen der Fachmann gemäß der Beschreibung herzustellen weiß.

Die Verschlusselemente könnten vorteilhafterweise mittels Kugelbonds (engl. "solder balls") an den Träger gebondet werden. Bevorzugt sind die Verschlusselemente als Leiterplatten oder als integrierte Schaltungen ausgebildet. Zur mechanischen Verstärkung der Verschlusselemente können diese einen zusätzlichen Träger, z.B. aus einem FR4-Material, aufweisen. FR4 oder FR-4 (aus dem Engl. "flame retardant") bezeichnet eine Klasse von schwer entflammbaren und flammenhemmenden Verbundwerkstoffen bestehend aus Epoxidharz und Glasfasergewebe. Bei der vorliegenden Erfindung ist ein FR4-Material als elektrisch nicht leitendes Trägermaterial bei elektrischen Leiterplatten einsetzbar.

Die Verschlusselemente können auch an den Träger angelötet werden, wobei die Verschlusselemente in Form von "Quad Flat No Leads Packages" (QFN), auch als "Micro Lead Frame" (MLF) bezeichnet, hergestellt werden. Unter Verwendung einer Packagingtechnik für integrierte Schaltungen können die Verschlusselemente auch durch Strukturieren von metallischen Schichten an Oberflächen eines Moldmaterial hergestellt werden, oder als embedded wafer level ball grid (eWLB).

In einem nicht beanspruchten Beispiel ist das Sendeelement als ein erster Abschnitt der ersten metallischen Schicht ausgebildet. Gemäß einer Ausführungsform ist das Empfangselement als ein erster Abschnitt der zweiten metallischen Schicht ausgebildet. Vorteilhafterweise sind das Sendeelement und/oder das Empfangselement als Mikrostreifenantennen ausgebildet.

Gemäß einer Ausführungsform ist an der ersten Oberfläche des Trägers eine erste nichtleitende Schicht ausgebildet, welche den Durchgang an der ersten Oberfläche verschließt. Gemäß einer Ausführungsform ist an der zweiten Oberfläche des Trägers eine zweite nichtleitende Schicht ausgebildet, welche den Durchgang an der zweiten Oberfläche verschließt.

In einem nicht beanspruchten Beispiel ist das Sendeelement an der ersten nichtleitenden Schicht angeordnet, vorzugsweise an einer von dem Durchgang abgewandten Oberfläche der ersten nichtleitenden Schicht. Gemäß einer Ausführungsform ist das Empfangselement an der zweiten nichtleitenden Schicht angeordnet, vorzugsweise an einer von dem Durchgang abgewandten Oberfläche der zweiten nichtleitenden Schicht.

Gemäß einer Ausführungsform umfasst die Vorrichtung mindestens ein Antennenelement, welches an oder auf der zweiten Oberfläche des Trägers angeordnet ist und welches mit dem Empfangselement zum Übertragen des Hochfrequenzsignals von dem Empfangselement an das Antennenelement galvanisch oder elektromagnetisch verbunden ist. Somit ist eine Antenneneinrichtung, welche insbesondere mindestens ein Antennenelementaufweist, großflächig an oder auf der zweiten Oberfläche des Trägers ausbildbar, während das Hochfrequenzsignal zum Betreiben der mindestens einen Sendeantenne platzsparend an oder auf der zweiten Oberfläche des Trägers erzeugbar oder anlegbar ist. Somit wird die für die Antennenelemente nutzbare Oberfläche des Trägers maximiert.

Gemäß einer Ausführungsform umfasst die Vorrichtung eine Hochfrequenzsignal-Erzeugungseinrichtung zum Erzeugen des Hochfrequenzsignals, welche an oder auf der ersten Oberfläche des Trägers angeordnet ist. Die Hochfrequenzsignal-Erzeugungseinrichtung ist zum Übertragen des Hochfrequenzsignals von der Hochfrequenzsignal-Erzeugungseinrichtung an das Sendeelement mit dem Sendeelement insbesondere galvanisch verbunden. Somit ist ein Ort des Erzeugens des Hochfrequenzsignals an der ersten Oberfläche des Trägers ausgebildet, während das Hochfrequenzsignal an der zweiten Oberfläche des Trägers abgreifbar ist, wodurch die zweite Oberfläche zu einem besonders großen Anteil mit Nutzstrukturen, beispielsweise Antennenelementen, versehen werden kann. Gemäß einer Ausführungsform umfasst das Verfahren weiterhin die Schritte: Übertragen des an das Empfangselement übertragenen Hochfrequenzsignals über eine galvanische Verbindung an mindestens eine Sendeantenne; und Aussenden einer elektromagnetischen Welle durch das mindestens eine Antennenelement, basierend auf dem an das mindestens eine Antennenelement übertragenen Hochfrequenzsignal.

### Kurze Beschreibung der Zeichnungen

Die vorliegende Erfindung wird nachfolgend anhand der in den schematischen Figuren der Zeichnungen dargestellten Ausführungsbeispiele näher erläutert. Es zeigen:
- Fig. 1: ein schematisches Blockschaltbild zum Erläutern einer Vorrichtung zum Übertragen eines Hochfrequenzsignals gemäß einer ersten Ausführungsform der vorliegenden Erfindung;
- Fig. 2: ein schematisches Blockschaltbild zum Erläutern einer Vorrichtung zum Übertragen eines Hochfrequenzsignals gemäß einer zweiten Ausführungsform der vorliegenden Erfindung;
- Fig. 3-5: schematisch Details des ersten Verschlusselements gemäß der zweiten Ausführungsform der vorliegenden Erfindung;
- Fig. 6: in schematisches Blockschaltbild zum Erläutern einer Vorrichtung zum Übertragen eines Hochfrequenzsignals gemäß einer dritten Ausführungsform der vorliegenden Erfindung;
- Fig. 7-9: schematisch Details des ersten Verschlusselements gemäß der dritten Ausführungsform der vorliegenden Erfindung; und
- Fig. 10: ein schematisches Flussdiagramm zum Erläutern eines Verfahrens zum Übertragen eines Hochfrequenzsignals gemäß einer vierten Ausführungsform der vorliegenden Erfindung.

In allen Figuren sind gleiche bzw. funktionsgleiche Elemente und Vorrichtungen -

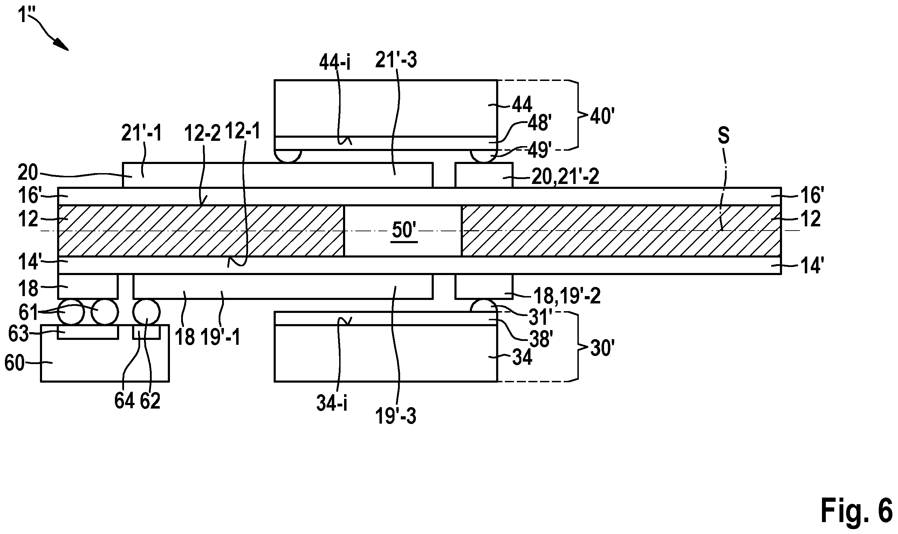

sofern nichts anderes angegeben ist - mit denselben Bezugszeichen versehen. Die Ausführungsform der Fig. 6-9 ist nur teilweise im Schutzumfang inbegriffen. Die Alternative, bei der das Sendeelement der ersten nicht-leitenden Schicht zugewiesen ist, ist nämlich nicht kompatibel mit Anspruch 1. Die restlichen Alternativen von diesem Anspruch sind aber Teil des Schutzumfangs.

### Beschreibung der Ausführungsbeispiele

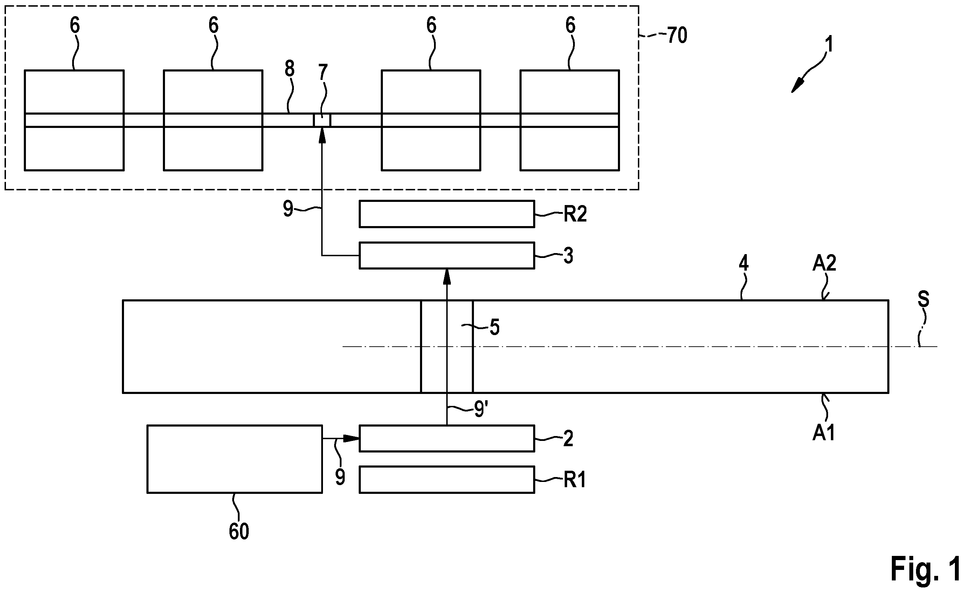

Fig. 1 zeigt ein schematisches Blockschaltbild zum Erläutern einer Vorrichtung 1 zum Übertragen eines Hochfrequenzsignals 9 gemäß einer ersten Ausführungsform der vorliegenden Erfindung.

Die Vorrichtung 1 umfasst einen Träger 4, durch welchen hindurch ein Durchgang 5 von einer ersten Oberfläche A1 des Trägers 4 zu einer zweiten Oberfläche A2 des Trägers ausgebildet ist. Die erste Oberfläche A1 ist parallel zu der zweiten Oberfläche A2 und von der zweiten Oberfläche A2 abgewandt.

Auf oder an der ersten Oberfläche A1 ist eine optionale, Hochfrequenzsignal-Erzeugungseinrichtung 60 angeordnet. Mittels der Hochfrequenzsignal-Erzeugungseinrichtung 60 ist ein Hochfrequenzsignal 9 erzeugbar. Die Hochfrequenzsignal-Erzeugungseinrichtung 60 ist elektromagnetisch und/oder elektrisch, z.B. über eine galvanische Verbindung, mit einem Sendeelement 2 verbunden, welches an oder auf der ersten Oberfläche A1 des Trägers 4 im Bereich des Durchgangs 5 angeordnet ist. Insbesondere überdeckt eine geometrische Projektion des Sendeelements 2 auf die erste Oberfläche A1 die Öffnung des Durchgangs 5 in der ersten Oberfläche A1 vollständig.

An oder auf der zweiten Oberfläche A2 ist ein Empfangselement 3 im Bereich des Durchgangs 5 angeordnet. Insbesondere überdeckt eine geometrische Projektion des Empfangselement 3 auf die zweite Oberfläche A2 die Öffnung des Durchgangs 5 in der zweiten Oberfläche A2 vollständig. Das Sendeelement 2 und das Umfangselement 3 sind galvanisch voneinander getrennt.

Das Sendeelement 2 ist zwischen dem Träger 4 und einem ersten Reflektorelement R1 angeordnet, welches aus der Richtung des Durchgangs 5 einfallende elektromagnetische Wellen in Richtung des Durchgangs 5 reflektiert. Das Empfangselement 3 ist optional zwischen dem Träger 4 und einem optionalen zweiten Reflektorelement R2 angeordnet, welches dazu geeignet ist, aus der Richtung des Durchgangs 5 einfallende elektromagnetische Wellen in Richtung des Durchgangs 5 zu reflektieren. In einigen Ausführungsformen kann das zweite Reflektorelement R2 entfallen. Vorzugsweise sind das Sendeelement 2 und das Empfangselement 3 spiegelsymmetrisch zueinander bezüglich einer Symmetrieebene S, welche parallel zu den Oberflächen A1, A2 des Trägers 4 und, vorzugsweise auf halbem Weg, zwischen der ersten und zweiten Oberfläche A1, A2 angeordnet ist. Vorzugsweise sind außerdem auch das erste und das zweite Reflektorelement R1, R2 spiegelsymmetrisch zueinander bezüglich der Symmetrieebene S.

Das über die galvanische Verbindung von der Hochfrequenzsignal-Erzeugungseinrichtung 60 an das Sendeelement 2 übertragene Hochfrequenzsignal 9 ist mittels des Sendeelements 2 über den Durchgang 5 als elektromagnetische Welle 9' an das Empfangselement 3 übertragbar. Der Durchgang 5 durch den Träger 4 kann nach außen, das heißt an eine Außenseite der Vorrichtung 1 hin offen sein. Der Durchgang 5 kann aber auch ein- oder beidseitig verschlossen sein. Ist der Durchgang 5 beidseitig verschlossen, kann er beispielsweise mit einem Gas oder Gasgemisch gefüllt sein oder ein - technisch erzeugbares - Vakuum umschließen.

Optional umfasst die Vorrichtung 1 eine Antenneneinrichtung 70, welche auf oder an der zweiten Oberfläche A2 des Trägers 4 angeordnet ist. Die Antenneneinrichtung 70 umfasst ein oder mehrere Antennenelemente 6, wobei in Fig. 1 beispielhaft vier Antennenelemente 6 dargestellt sind, welche beispielsweise in Mikrostreifentechnologie ausgebildet sind und mittels einer Leitung 8, z.B. einer Mikrostreifenleitung, mit einem Einspeisepunkt 7 elektromagnetisch und/oder elektrisch, z.B. galvanisch, verbunden sind. Der Einspeisepunkt 7 ist elektromagnetisch und/oder elektrisch, z.B. galvanisch, mit dem Sendeelement 3 derart verbunden, dass das an dem Sendeelement 3 als elektromagnetische Welle 9' empfangene Hochfrequenzsignal 9 an den Einspeisepunkt 7 und somit an die Antenneneinrichtung 70 übertragbar ist. Die Antenneneinrichtung 70 ist mittels des übertragenen Hochfrequenzsignals9 betreibbar. Vorzugsweise ist der Einspeisepunkt 7 auf dem Mittelpunkt der Leitung 8 angeordnet, sodass die Zuleitungswege für das Hochfrequenzsignal 9 von dem Einspeisepunkt 7 an die Antennenelemente 6 minimiert werden..

Das Hochfrequenzsignal 9 kann beispielsweise auch von einer externen Hochfrequenzsignal-Erzeugungseinrichtung über eine galvanische Verbindung an das Sendeelement 2 übertragbar sein. Das Hochfrequenzsignal kann auch, statt durch die Antenneneinrichtung 70 abgestrahlt, an dem Einspeisepunkt 7 abgegriffen werden, z.B. zur Erregung weiterer Leitungen.

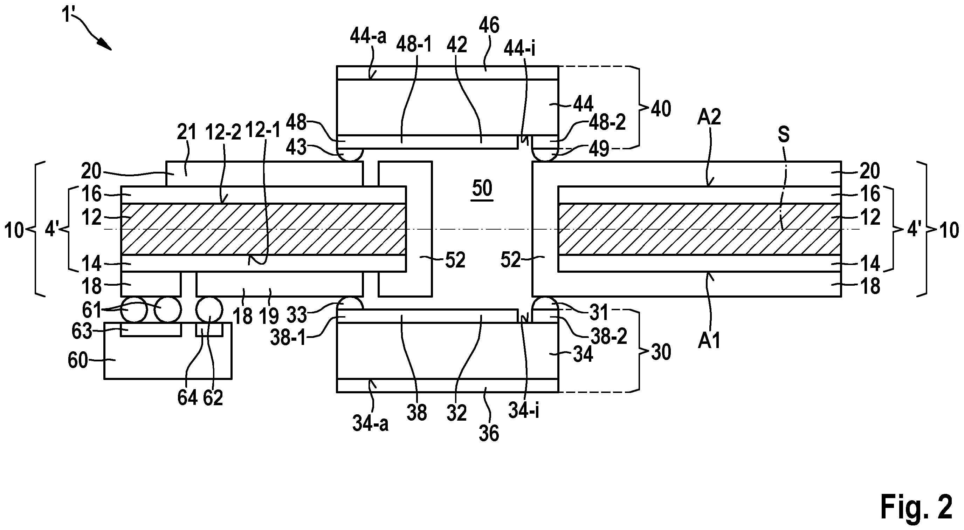

Fig. 2 zeigt eine schematische Darstellung einer Vorrichtung 1' zum Übertragen eines Hochfrequenzsignals. Der Träger 4' der Vorrichtung 1' weist eine Mittelschicht 12 auf, welche aus einem z.B. FR4-Material ausgebildet ist. Diese Mittelschicht 12 kann auch eine Vielschichtstruktur mit partielle leitenden und nicht-leitenden Einzelschichten sein. Die Mittelschicht 12 fungiert als Masse und/oder ist geerdet, bzw. eine oder mehrere der Einzelschichten der Vielschichtstruktur können geerdet sein.

An einer ersten Oberfläche 12-1 der Mittelschicht 12 ist eine erste elektrisch nicht-leitende Schicht 14 ausgebildet und an einer zweiten Oberfläche 12-2 der Mittelschicht 12, welche von der ersten Oberfläche 12-1 der Mittelschicht 12 abgewandt und zu dieser parallel angeordnet ist, ist eine zweite elektrisch nicht-leitende Schicht 16 ausgebildet. Die erste und die zweite elektrisch nicht-leitende Schicht 14, 16 sind aus z.B. einem Hochfrequenzmaterial (Englisch "RFsubstrate") ausgebildet, beispielsweise aus Teflon oder einer Keramik oder einem Flüssigkristallpolymer (FKP, Englisch: "Liquid Crystal Polymer", LCP).

Die Schichtstruktur, bestehend aus der Mittelschicht 12 und der sie sandwichartig einklemmenden ersten und zweiten elektrisch nicht-leitenden Schichten 14, 16, entspricht einem Träger 4' gemäß der zweiten Ausführungsform der vorliegenden Erfindung. An der ersten Oberfläche A1 des Trägers 4', welche über der ersten Oberfläche 12-1 der Mittelschicht 12 angeordnet ist, ist eine erste strukturierte leitende Schicht 18 ausgebildet. An der zweiten Oberfläche A2 des Trägers 4', welche über der zweiten Oberfläche 12-2 der Mittelschicht 12 angeordnet ist, ist eine zweite strukturierte leitende Schicht 20 ausgebildet. Der Träger 4' bildet zusammen mit der ersten und der zweiten strukturierten elektrisch leitenden Schicht 18, 20 eine Leiterplatte 10.

Durch den Träger 4' hindurch, von der ersten Oberfläche A1 bis zur zweiten Oberfläche A2, erstreckt sich ein Durchgang 50, welcher weder an der ersten Außenfläche A1 durch die erste elektrisch leitende Schicht 18 noch an der zweiten Oberfläche A2 durch die zweite elektrisch leitende Schicht 20 überdeckt ist. Der Durchgang 50 ist an seinen Wänden innerhalb des Trägers 4' mittels einer Metallisierung 52 metallisiert, wobei je nach der gewünschten Anwendung eine Verbindung zwischen Teilen oder isolierten Abschnitten der ersten elektrisch leitenden Schicht 18 und Teilen, insbesondere zwischen ansonsten elektrisch isolierten Abschnitten der zweiten elektrisch leitenden Schicht 20 herstellbar ist.

An der ersten elektrisch leitenden Schicht 18 ist über eine erste elektromagnetische Verbindung 61, gemäß der zweiten Ausführungsform hier in Form von Kugelbonds, die Hochfrequenzsignal-Erzeugungseinrichtung 60 angebondet. Über die erste elektromagnetische Verbindung 61 sind beispielsweise Steuersignale an eine Signaleingangseinrichtung 63 der Hochfrequenzsignal-Erzeugungseinrichtung 60 übermittelbar, basierend auf welchen die Hochfrequenzsignal-Erzeugungseinrichtung 60 das Hochfrequenzsignal 9 erzeugt. Über mindestens eine zweite elektromagnetische und/oder elektrische Verbindung 62 (hier im Form von Kugelbondsdargestellt), welche mit einer Signalausgabeeinrichtung 64 der Hochfrequenzsignal-Erzeugungseinrichtung 60 elektromagnetisch und/oder galvanisch verbunden ist, ist die Hochfrequenzsignal-Erzeugungseinrichtung 60 über einen ersten Abschnitt 19 der ersten elektrisch leitenden Schicht 18 galvanisch mit dem Sendeelement 32 verbunden. Dazu kann elektrisch zwischen dem ersten Abschnitt 19 der ersten elektrisch leitenden Schicht 18 und dem Sendeelement 32 eine erste galvanische Verbindung 33, gemäß der zweiten Ausführungsform als Kugelbond, ausgebildet sein. Somit sind durch die Hochfrequenzsignal-Erzeugungseinrichtung 60 erzeugbare Hochfrequenzsignale an der Signalausgabeeinrichtung 64 ausgebbar und an das Sendeelement 32 übertragbar.

Über die erste galvanische Verbindung 33 sowie über eine zweite galvanische Verbindung 31, gemäß der zweiten Ausführungsform durch einen Kugelbond ausgebildet und dargestellt, ist ein erstes Verschlusselement 30 im Bereich des Durchgangs 50 mechanisch mit dem Träger 4' verbunden. Durch die zweite galvanische Verbindung 31 ist das erste Verschlusselement 30 elektrisch verbunden mit einem galvanisch von dem ersten Abschnitt 19 getrennten Abschnitt der ersten elektrisch leitenden Schicht 18, insbesondere mit Masse.

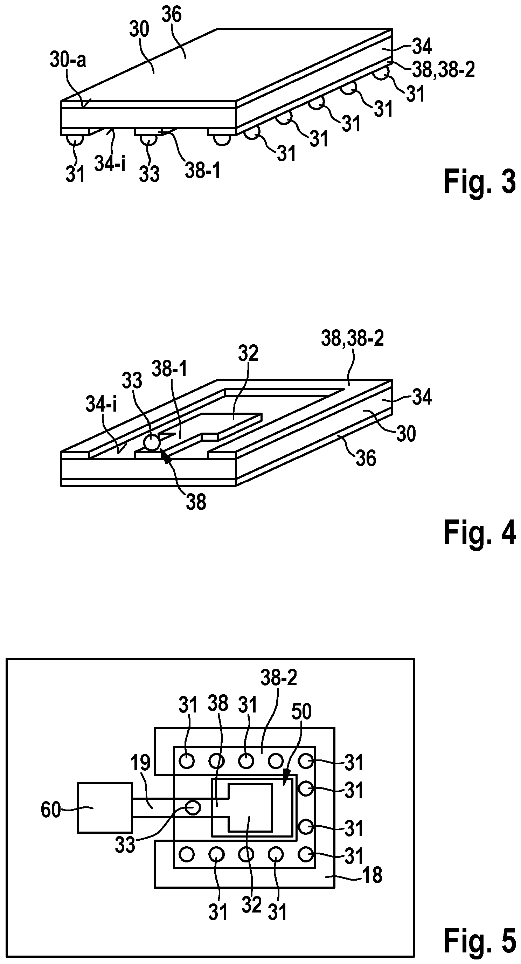

An einer ersten Oberfläche 34-i eines nicht-leitenden Trägers 34 des ersten Verschlusselements 30, welcher der Klarheit halber im Folgenden als zweiter Träger 34 bezeichnet wird ist eine erste strukturierte metallische Schicht 38 ausgebildet (s. Details in Fig. 3 bis 5). Die erste Oberfläche 34-i ist dem Träger 4' und dem Durchgang 50 zugewandt. Die erste strukturierte metallische Schicht 38 weist zwei galvanisch voneinander getrennte Abschnitte 38-1, 38-2 auf. Der erste Abschnitt 38-1 der ersten strukturierten metallischen Schicht 38 ist galvanisch mit der ersten galvanischen Verbindung 33 verbunden. Die zweite galvanische Verbindung 31, welche in den Fig. 4 und 5 beispielhaft als zwölf Kugelbonds dargestellt ist, stellt eine mechanische und erdende Verbindung zwischen dem Träger 4', insbesondere mit der ersten elektrisch leitenden Schicht 18 und dem nicht-leitenden zweiten Träger 34 des ersten Verschlusselements 30 her.

Das erste Verschlusselement 30 entspricht dem Sendeelement 3 und dem Reflektorelement R1 gemäß der ersten Ausführungsform und ist in den Figuren 3-5 aus verschiedenen Ansichten noch genauer dargestellt.

Fig. 3 zeigt zur Veranschaulichung das erste Verschlusselement 30 isoliert aus einer ersten Schrägansicht. Auf einer von der ersten Oberfläche 34-i des zweiten Trägers 34 des ersten Verschlusselements 30 abgewandten zweiten Oberfläche 34-a des zweiten Trägers 34 des ersten Verschlusselements 30 ist ganzflächig eine dritte metallische Schicht 36 als ein erstes Reflektorelement ausgebildet. Die dritte metallische Schicht 36 dient insbesondere zum Reflektieren von elektromagnetischen Wellen, welche mittels des Sendeelements 32 in eine Richtung, welche von dem Träger 4' fortweist, durch den zweiten Träger 34 hindurch ausgesendet werden. Auf diese Weise kann ein Leistungsverlust und/oder ein Entstehen von Störsignalen für außerhalb der Vorrichtung 1' angeordnete Geräte vermieden werden. Um unerwünschte elektromagnetische Strahlung weiter zu verringern, können optional Kontaktierungen (z.B. Vias, Mikrovias, Through-Mold-Durchkontaktierungen (engl.: "through-mold-vias", TMV)) durch das Material des zweiten Trägers 34 hindurch den zweiten Abschnitt 38-2 der ersten metallischen Schicht 38 galvanisch mit der dritten metallischen Schicht 36 verbinden (in Fig. 3 bis 5 nicht dargestellt) Fig. 4 zeigt eine zweite schematische Schrägansicht des ersten Verschlusselements 30, bei dem die dem Träger 4' zugewandte erste Oberfläche 34-i des zweiten Trägers 34 sowie die erste metallische Schicht 38 sichtbar sind. Die zweite galvanische Verbindung 31 in Form der Kugelbonds ist nicht dargestellt. Der zweite Abschnitt 38-2 der ersten metallischen Schicht 38 ist entlang dreier Kanten des rechteckig geformten ersten Verschlusselements 30 direkt an der ersten Oberfläche 34-i des zweiten Trägers 34 angeordnet, beispielsweise aufgedampft. Die erste galvanische Verbindung 31 ist an der vierten Kante des ersten Verschlusselements 30 angeordnet. Der zweite Abschnitt 38-2 kann auch teilweise an der vierten Kante angeordnet sein, wobei er galvanisch von der ersten galvanischen Verbindung 33 und dem ersten Abschnitt 38-1 getrennt ist. In Fig. 3 bis 5 ist das erste Verschlusselement 30 beispielsweise als rechteckig dargestellt, es kann aber auch andere Formen annehmen, z.B. runde Formen.

Der erste Abschnitt 38-1 weitet sich zur geometrischen Mitte der Quadratform des ersten Verschlusselements 30 hin zu dem ersten Sendeelement 32 auf. Das erste Sendeelement 32 kann beispielsweise als Mikrostreifenantenne realisiert werden, wie in Fig. 4-5 dargestellt, aber auch z.B. als "coplanar wave guide" (CPW) oder Schlitzelement. Abhängig davon, welche Technologie für das erste Sendeelement 32 benutzt wird, kann optional die dritte metallische Schicht 36 vorgesehen werden oder nicht. Das erste Sendeelement 32 ist in Fig. 4-5 beispielsweise quadratisch dargestellt, kann aber auch andere Formen haben (z.B. rechteckig mit abgerundeten Kanten, rund, Diamant-Form usw.) und seine Position auf der ersten Oberfläche 34-i kann von der geometrischen Mitte der ersten Oberfläche 34-i des zweiten Trägers 34 abweichen. Der zweite Träger 34 kann ein Leiterplatte-Material aufweisen (wie FR4, Keramik, usw.) aber auch z.B. Moldmaterial oder Glas aufweisen oder daraus bestehen. Der zweite Träger kann auch eine Vielschichtstruktur sein.

Fig. 5 zeigt eine schematische Draufsicht auf die Vorrichtung 1' auf die erste Oberfläche A1, wobei das erste Verschlusselement 30 teilweise durchsichtig dargestellt ist. Aus Fig. 5 ist ersichtlich, dass das erste Sendeelement 32 rechteckig geformt ist, wobei eine erste geometrische Projektion des ersten Sendeelements 32 auf die erste Oberfläche A1 von einer zweiten geometrischen Projektion des Durchgangs 50 auf die erste Oberfläche A1 sowie von der Öffnung des Durchgangs 50 in der ersten Oberfläche A1 überdeckt wird. Die erste geometrische Projektion kann komplett oder auch nur teilweise abgedeckt sein, d.h. eine Fläche des ersten Sendeelements 32 kann größer oder kleiner als ein Querschnitt des Durchgangs 50 sein. Der geometrische Mittelpunkt des Sendeelements 32 kann von dem geometrischen Mittelpunkt des Durchgangs 50 abweichen.

Auf der zweiten Oberfläche A2 des Trägers 4' ist das zweite Verschlusselement 40 angeordnet, welches in Bezug auf eine Symmetrieebene S, welche parallel zu den Oberflächen A1, A2 des Trägers 4' und zwischen der ersten und zweiten Oberfläche A1, A2 angeordnet ist, ein Spiegelbild des ersten Verschlusselements 30 darstellt. Somit weist das zweite Verschlusselement 40 einen dritten elektrisch nichtleitenden Träger 44 mit einer ersten Oberfläche 44-i des dritten Trägers 44 auf, welche dem Träger 4' zugewandt ist, und an welcher wiederum eine zweite metallische Schicht 48 angebracht ist. Die zweite metallische Schicht 48 besteht aus einem ersten Abschnitt 48-1, welcher über eine dritte galvanische Verbindung 43 (z.B. über einen Kugelbond) an einen ersten Abschnitt 21 der zweiten elektrisch leitenden Schicht 20 galvanisch angebunden ist. Somit ist an dem ersten Abschnitt 21 der zweiten elektrisch leitenden Schicht 20 das Hochfrequenzsignal 9 abgreifbar, beispielsweise zum Einspeisen in den Einspeisepunkt 7 der Antenneneinrichtung 70.

Die zweite metallische Schicht 48 weist weiterhin einen zweiten Abschnitt 48-2 auf, welcher in Bezug auf die Symmetrieebene S ein Spiegelbild des zweiten Abschnitts 38-2 der ersten metallischen Schicht 38 darstellt und welcher daher auch von dem ersten Abschnitt 48-1 der zweiten metallischen Schicht 48 galvanisch getrennt ist. Über eine vierte galvanische Verbindung 49 (z.B. Kugelbonds) ist der zweite Abschnitt 48-2, beispielsweise zur Erdung, galvanisch mit der zweiten elektrisch leitenden Schicht 20 verbunden.

Der erste Abschnitt 48-1 der zweiten metallischen Schicht 48 ist spiegelbildlich, bezüglich der Symmetrieebene S, zu dem ersten Abschnitt 38-1 der ersten metallischen Schicht ausgebildet, so dass er sich zur geometrischen Mitte der Rechtecksform des zweiten Verschlusselements 40 hin zu einem als Mikrostreifenantenne ausgebildeten Empfangselement 42 verbreitert. Wie für das erste Verschlusselement 30 beschrieben, kann auch das zweite Verschlusselement 40 neben einer quadratischen Form des Empfangselements 42 auch andere Formen, z.B. runde, aufweisen; und das Empfangselement 42 kann von einem geometrischen Mittelpunkt der ersten Oberfläche 44-i des dritten Trägers 44 abweichen, wie oben beschrieben.

An einer zweiten Oberfläche 44-a des dritten Trägers 44 ist, bezüglich der Symmetrieebene S spiegelbildlich zur dritten metallischen Schicht 36, eine vierte metallische Schicht 46 ausgebildet, welche die zweite Oberfläche 44-a des dritten Trägers 44 vollständig bedeckt. Die vierte metallische Schicht 46 dient als zweites Reflektorelement zur Reflektion von elektromagnetischen Wellen aus der Richtung des Durchgangs 50 in die Richtung des Durchgangs 50 und somit auch in die Richtung des Empfangselements 42. Um unerwünschte elektromagnetische Strahlung weiter zu verringern, können optional Kontaktierungen (z.B. Vias, Through-Mold-Durchkontaktierungen (engl.: "through-mold-vias", TMV) usw.) durch das Material des dritten Trägers 44 hindurch den zweiten Abschnitt 48-2 der zweiten metallischen Schicht 48 galvanisch mit der vierten metallischen Schicht 46 verbinden (Kontaktierungen und Vias nicht dargestellt). Die für das erste Verschlusselement 30 bezüglich der Fertigungstechnologien des Sendeelements 32 beschriebenen Optionen gelten analog auch für das Empfangselement 42. Der dritte Träger 44 kann wie der zweite Träger 34 ein Leiterplatte-Material (wie FR4, Keramik, usw.) aber auch z.B. Moldmaterial und/oder Glas aufweisen oder daraus bestehen und kann auch als eine Vielschichtstruktur ausgebildet sein.

Fig. 6 zeigt eine schematische Querschnittsansicht durch eine Vorrichtung 1"

gemäß einer dritten Ausführungsform der vorliegenden Erfindung.

Das erste Verschlusselement 30' und die Position des Sendeelements 32, 19'-3 , die im Zusammenhang mit der Vorrichtung 1" beispielshalber beschrieben werden, sind aber nicht kompatibel mit der beanspruchten Merkmalskombination.

Die Vorrichtung 1" ist eine Variante der Vorrichtung 1', wobei die Unterschiede im Folgenden genauer erläutert werden.

In der Vorrichtung 1" ist eine Mittelschicht 12 an einer ersten Oberfläche 12-1 mit einer ersten nicht-leitenden Schicht 14' verbunden, welche aus z.B. einem Hochfrequenzmaterial gefertigt ist. An einer zweiten Oberfläche 12-2 der Mittelschicht 12 ist eine zweite nicht-leitende Schicht 16' angeordnet, welche aus z.B. Hochfrequenzmaterialien ausgebildet ist, vorzugsweise aus den gleichen Materialien wie die erste nicht-leitende Schicht 14'. Die Mittelschicht 12 kann auch eine Vielschichtstruktur sein. Bei der Vorrichtung 1" ist der Durchgang 50' von der ersten Oberfläche 12-1 bis zu der zweiten Oberfläche 12-2 der Mittelschicht 12 ausgebildet, wobei die zweite Oberfläche 12-2 der Mittelschicht 12 zu der ersten Oberfläche 12-1 parallel ist und von dieser abgewandt ist. Im Unterschied zur zweiten Ausführungsform bedecken jedoch sowohl die erste nicht-leitende Schicht 14' auf der ersten Oberfläche 12-1 als auch die zweite nicht-leitende Schicht 16' an der zweiten Oberfläche 12-2 der Mittelschicht 12 vollständig den Durchgang 50', so dass der Durchgang 50' keinen Zugang an die Außenseite der Vorrichtung 1" aufweist, d.h. der Durchgang 50' ist als eine Kavität bezeichenbar. Als Träger wird bei der Vorrichtung 1" die Mittelschicht 12 bezeichnet.

Bei der Vorrichtung 1" verbreitert sich ein erster Abschnitt 19'-1 der an der ersten nicht-leitenden Schicht 14' angeordneten ersten metallischen Schicht 18 im Bereich des Durchgangs 50' zu einem Sendeelement 19'-3 (beispielsweise ausgebildet als eine Mikrostreifenantenne, aber auch einer CPW-Antenne oder einer Antenne gemäß einer anderen Technologie). Die erste Antenne 19'-3 ist derart ausgebildet, dass die erste geometrische Projektion der ersten Antenne 19'-3 auf die erste Oberfläche 12-1 von der zweiten geometrischen Projektion des Durchgangs 50' auf die erste Oberfläche 12-1 bedeckt ist. Die erste geometrische Projektion kann komplett oder auch nur teilweise abgedeckt sein, d.h. eine Fläche der ersten Antenne 19'-3 kann größer oder kleiner als ein Querschnitt des Durchgangs 50' sein. Der geometrische Mittelpunkt des Sendeelements 19'-3 kann von dem geometrischen Mittelpunkt des Durchgangs 50' abweichen.

Wie auch bei der Vorrichtung 1' ist bei der Vorrichtung 1" an einer ersten Oberfläche 34-i des zweiten Trägers 34, welche der Mittelschicht 12 zugewandt ist, ganzflächig, d.h. vollständig, eine erste metallische Schicht 38' ausgebildet, welche als erstes Reflektorelement dient. Die erste metallische Schicht 38' ist über eine galvanische Verbindung 31' (z.B. Kugelbonds) zur Erdung an einem zweiten Abschnitt 19'-2 der ersten elektrisch leitenden Schicht 18 angebondet.

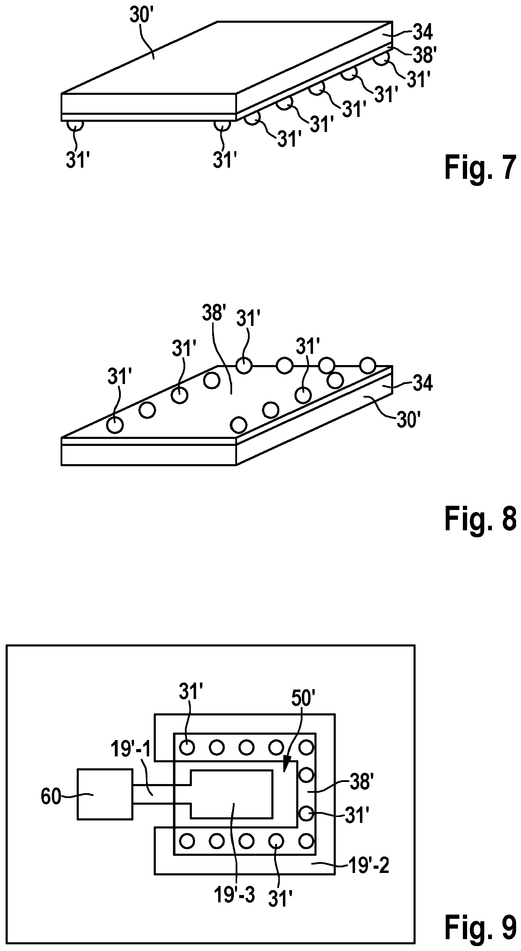

Der zweite Abschnitt 19'-2 ist galvanisch von dem ersten Abschnitt 19'-1 der ersten elektrisch leitenden Schicht 18 getrennt. Die Kugelbonds der galvanischen Verbindung 31' sind in Fig. 6 der Übersichtlichkeit halber nicht, dafür aber in den Fig. 7 bis 9 dargestellt (hier sind beispielhaft zwölf Kugelbonds dargestellt). Dabei ist ersichtlich, dass die galvanische Verbindung 31' die erste metallische Schicht 38' mit demjenigen Abschnitt der ersten elektrisch leitenden Schicht 18 galvanisch verbindet, welcher galvanisch von dem Sendeelement 19'-3 getrennt ist.

Auf der zweiten Oberfläche 12-2 der Mittelschicht 12, insbesondere an der zweiten nicht-leitenden Schicht 16' ist wiederum ein erster Abschnitt 21'-1 der zweiten elektrisch leitenden Schicht 20 ausgebildet, welcher sich im Bereich des Durchgangs 50' zu einem Empfangselement 21'-3 verbreitert (z.B. im Form einer Mikrostreifenantenne, CPW-Antenne, usw.). Das Sendeelement 19'-3 und das Empfangselement 21'-3 sind Spiegelbilder gemäß der Spiegelsymmetrieebene S, welche zwischen der ersten Oberfläche und der zweiten Oberfläche 12-1, 12-2 der Mittelschicht 12 und zu diesen parallel angeordnet ist. An dem ersten Abschnitt 21'-1 ist das Hochfrequenzsignal 9 abgreifbar. Gemäß der Ausführungsform 1" verläuft der Weg des Hochfrequenzsignals 9 also wie folgt:

Erzeugt von der Hochfrequenzsignal-Erzeugungseinrichtung 60, wird das Hochfrequenzsignal 9 über den ersten Abschnitt 19'-1 der ersten elektrisch leitenden Schicht 18 an das Sendeelement 19'-3 übertragen. Beispielsweise wird das Hochfrequenzsignal 9 an der Signalausgabeeinrichtung 64 der Hochfrequenzsignal-Erzeugungseinrichtung 60 ausgegeben und über den zweiten Kugelbond 62 und über den ersten Abschnitt 19'-1 der ersten elektrisch leitenden Schicht 18 an das Sendeelement 19'-3 übertragen. Das als erste Mikrostreifenantenne ausgebildete Sendeelement 19'-3 wird durch das Hochfrequenzsignal 9 zum Aussenden elektromagnetischer Wellen 9' angeregt, welche durch die erste nicht-leitende Schicht 14' im Bereich des Durchgangs 50', durch den Durchgang 50' sowie durch die zweite nicht-leitende Schicht 16' im Bereich des Durchgangs 50' hindurch an das als zweite Mikrostreifenantenne ausgebildete Empfangselement 21'-3 übertragen werden. Die erste und die zweite Mikrostreifenantenne sind als kapazitiv gekoppelt bezeichenbar. Das derart am Empfangselement 21'-3 empfangene Hochfrequenzsignal 9 wird sodann an den ersten Abschnitt 21'-1 der zweiten elektrisch leitenden Schicht 20 über eine galvanische Verbindung übertragen und ist dort abgreifbar, beispielsweise für eine Antenneneinrichtung 70, wie sie in Bezug auf die erste Ausführungsform beschrieben wurde.

Auch bei der Vorrichtung 1" ist das zweite Verschlusselement 40' bezüglich der Spiegelsymmetrieebene S spiegelbildlich zu dem ersten Verschlusselement 30' ausgebildet, so dass auch die zweite metallische Schicht 48' die erste Oberfläche 40'-i des zweiten Verschlusselements 40', welche dem Durchgang 50' zugewandt ist, ganzflächig, d.h. vollständig bedeckt und so als zweites Rückstrahlelement für aus der Richtung des Durchgangs 50' auftreffende elektromagnetische Wellen fungiert. Über eine sechste Verbindung 49' (z.B. Kugelbonds) ist die zweite metallische Schicht 48', beispielsweise zur Erdung, galvanisch mit einem zweiten Abschnitt 21'-2 der zweiten elektrisch leitenden Schicht 20 verbunden, welcher von dem ersten Abschnitt 21'-1 der zweiten elektrisch leitenden Schicht 20 galvanisch getrennt ist. Die Verschlusselemente 30', 40' sind in Abbildung 7 bis 9 schematisch dargestellt. In den Figuren sind die Verschlusselemente 30', 40' rechteckig dargestellt; diese können aber auch in andere geometrische Formen ausgebildet sein (z.B. rund sein). Das Sendeelement 19'-3 ist in Fig. 9 beispielsweise rechteckig dargestellt. Auch das Sendeelement 19'3 kann in anderen geometrischen Formen ausgebildet werden (rund, rechteckig mit abgerundeten Kanten, in einer Rautenform usw.) und ,mittels verschiedener Technologien (Mikrostreifen, CPW etc.) hergestellt werden. In Fig. 8 und Fig. 9 ist die galvanische Verbindung als zwölf Kugelbonds dargestellt. Es können auch mehr oder weniger Kugelbonds oder andere Bondmethoden verwendet werden.

Das erste und das zweite Verschlusselement 30', 40' können als metallisierter zweiter bzw. dritter Träger 34, 44 aus einem beliebigen planaren Material, z.B. aus einem FR4-Material ausgebildet sein. Das erste und das zweite Verschlusselement 30', 40' können aber alternativ auch ganz ohne zweiten und dritten Träger 34, 44 nur aus jeweils einem einfachen Metallplättchen, beispielsweise als Reflektorelement, ausgebildet sein. Es kann auch das erste Verschlusselement 30' mit dem zweiten Träger 34 ausgebildet sein und das zweite Verschlusselement 40' ohne den dritten Träger 44, oder umgekehrt. Die dritte und/oder die vierte metallische Schicht 36, 46 bei der Vorrichtung 1' können in der Vorrichtung 1" auch entfallen.

Ein Unterschied zwischen Vorrichtung 1' und Vorrichtung 1" ist, dass in Vorrichtung 1' das Sendeelement 32 an dem Verschlusselement 30 angeordnet ist und das Empfangselement 42 an dem Verschlusselement 40 angeordnet ist, während in Vorrichtung 1" das Sendeelement 19'-3 nicht an dem Verschlusselement 30', sondern an der ersten elektrisch nichtleitenden Schicht 14' getrennt von dem ersten Verschlusselement 30' angeordnet und das Empfangselement 21'-3 nicht an dem Verschlusselement 40', sondern an der zweiten elektrisch nichtleitenden Schicht 16' getrennt von dem zweiten Verschlusselement 40' angeordnet ist.

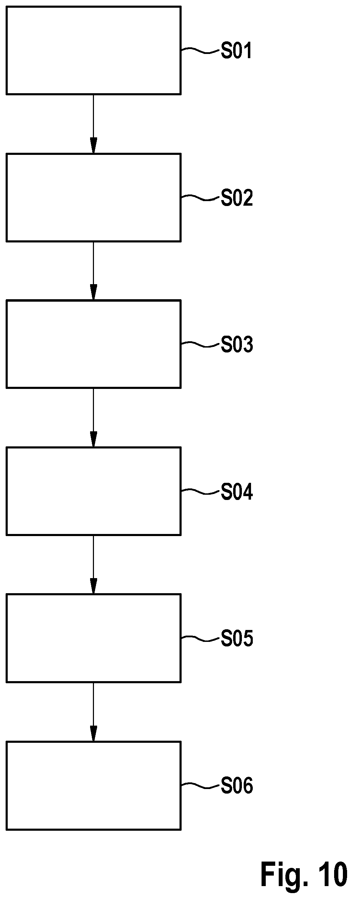

Fig. 10 zeigt ein schematisches Flussdiagramm zum Erläutern eines Verfahrens zum Übertragen eines Hochfrequenzsignals gemäß einer vierten Ausführungsform der vorliegenden Erfindung. Das Verfahren gemäß der vierten Ausführungsform ist zur Verwendung mit der Vorrichtung gemäß der ersten bis dritten Ausführungsform geeignet und kann speziell dazu ausgebildet sein. Insbesondere ist das Verfahren gemäß allen in Bezug auf die erste bis dritte Ausführungsform beschriebenen Varianten und Weiterbildungen der erfindungsgemäßen Vorrichtung anpassbar. Die Nummerierung von Verfahrensschritten dient der Übersichtlichkeit und soll insbesondere nicht, sofern nichts anderes angegeben ist, eine bestimmte zeitliche Reihenfolge implizieren. Insbesondere können auch mehrere Verfahrensschritte gleichzeitig durchgeführt werden.

In einem Schritt S01 wird ein Hochfrequenzsignal 9 bereitgestellt, beispielsweise mittels der Hochfrequenzsignal-Erzeugungseinrichtung 60 oder durch Anlegen eines extern erzeugten Hochfrequenzsignals 9.

In einem Schritt S02 wird das Hochfrequenzsignal 9 zumindest streckenweise, insbesondere vollständig, über eine galvanische Verbindung 19, 33, 38-1; 19'-1 an ein Sendeelement 2; 32; 19'-3 übertragen, welches an oder auf einer ersten Oberfläche A1; 12-1 eines elektrisch nichtleitenden Trägers 4; 4'; 12 ausgebildet ist.

In einem Schritt S03 wird das Hochfrequenzsignals 9 durch einen Durchgang 5; 50; 50', welcher von der ersten Oberfläche A1; 12-1 des Trägers 4; 4'; 12 zu einer zweiten Oberfläche A2; 12-2 des Trägers 4; 4'; 12 ausgebildet ist, als elektromagnetische Welle an ein Empfangselement 3; 42; 21'-3 übertragen, welches an oder auf der zweiten Oberfläche A2; 12-2 des Trägers 4; 4'; 12 ausgebildet ist.

In einem optionalen Schritt S04 werden, mittels eines ersten und eines zweiten Reflektorelements R1, R2; 36, 46; 38', 48', aus der Richtung des Durchgangs 5; 50;50' einfallende elektromagnetische Wellen in Richtung des Durchgangs 5; 50;50' reflektiert, wobei das Sendeelement 2; 32; 19'-3 zwischen dem Träger 4; 4'; 12 und dem ersten Reflektorelement R1; 36; 38' angeordnet ist und wobei das Empfangselement 3; 42; 21'-3 zwischen dem Träger 4; 4'; 12 und dem zweiten Reflektorelement R2; 46; 48' angeordnet ist.

In einem Schritt S05 wird das an das Empfangselement 3; 42; 21'-3 übertragene Hochfrequenzsignals 9 über eine galvanische Verbindung 48-1, 43, 21, 7, 8; 21'-1, 7, 8 an mindestens ein Antennenelement 6 oder an einen Einspeisepunkt 7 zu übertragen, an welchem das Hochfrequenzsignal abgreifbar ist, etwa zur Erregung der Antenneneinrichtung 70 oder weiterer elektrischer Leitungen.

In einem optionalen Schritt S06 wird eine weitere elektromagnetische Welle durch das mindestens eine Antennenelement 6 der Antenneneinrichtung 70, ausgesendet.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

Beispielsweise kann das erste Verschlusselement gemäß der zweiten Ausführungsform, welche das Sendeelement umfasst, auch mit dem zweiten Verschlusselement gemäß der dritten Ausführungsform kombiniert werden, welches von dem Empfangselement separat ausgebildet ist.

## Patentansprüche

1. Vorrichtung zum Übertragen eines Hochfrequenzsignals mit:
einem elektrisch nichtleitenden Träger (4; 4'; 12), durch welchen hindurch ein Durchgang (5; 50; 50') von einer ersten Oberfläche (A1; 12-1) des Trägers (4; 4'; 12) zu einer zweiten Oberfläche (A2; 12-2) des Trägers (4; 4'; 12) ausgebildet ist; einer ersten leitenden Schicht (18), welche auf der ersten Oberfläche (A1; 12-1) des Trägers (4; 4'; 12) ausgebildet ist und einen ersten Abschnitt (19,19'-1) und einen zweiten Abschnitt (19'-2) aufweist, welche galvanisch voneinander getrennt sind;
einem ersten Verschlusselement (30) mit einem ersten Reflektorelement (R1; 36), welches dazu ausgelegt ist, aus der Richtung des Durchgangs (5; 50;50') einfallende elektromagnetische Wellen in Richtung des Durchgangs (5; 50;50') zu reflektieren; einem Sendeelement (2; 32), welches an der ersten Oberfläche (A1; 12-1) des Trägers (4; 4'; 12) zwischen dem Träger (4; 4'; 12) und dem ersten Reflektorelement (R1; 36) angeordnet ist und an welches über den ersten Abschnitt (19,19'-1) der ersten leitenden Schicht (18) das Hochfrequenzsignal (9) anlegbar ist; und einem Empfangselement (3; 42; 21'-3), welches auf oder an der zweiten Oberfläche (A2; 12-2) des Trägers (4; 4'; 12) angeordnet ist und welches von dem Sendeelement (2; 32) galvanisch getrennt ist; wobei das erste Verschlusselement (30) einen weiteren nicht-leitenden Träger (34) umfasst, und wobei das erste Verschlusselement (30) auf einer dem Durchgang (5; 50;50') zugewandten Seite (34-i) des weiteren nicht-leitenden Trägers (34) eine strukturierte metallische Schicht (38) mit einem ersten Abschnitt (38-1) und einem zweiten Abschnitt (38-2) umfasst, wobei der erste Abschnitt (38-1) der strukturierten metallischen Schicht (38) das Sendeelement (2; 32) umfasst und galvanisch über eine erste galvanische Verbindung (33) mit dem ersten Abschnitt (19,19'-1) der ersten leitenden Schicht (18) verbunden ist, und der zweite Abschnitt (38-2) der strukturierten metallischen Schicht (38) über eine galvanische Verbindung (31') mit dem zweiten Abschnitt (19'-2) der ersten leitenden Schicht (18) verbunden ist; und
wobei mittels des Sendeelements (2; 32) das angelegte Hochfrequenzsignal (9) durch den Durchgang (5; 50; 50') durch den Träger (4; 4'; 12) hindurch als elektromagnetische Welle (9') an das Empfangselement (3; 42; 21'-3) übertragbar ist.

2. Vorrichtung nach Anspruch 1,
mit einer zweiten leitenden Schicht (20), welche auf der zweiten Oberfläche (A2; 12-2) ausgebildet ist und einen ersten Abschnitt (21) und einen zweiten Abschnitt aufweist, welche galvanisch von einander getrennt sind;
wobei das Empfangselement (3; 42; 21'-3) zwischen dem Träger (4; 4'; 12) und einem zweiten Reflektorelement (R2; 46; 48') angeordnet ist, welches dazu ausgelegt ist, aus der Richtung des Durchgangs (5; 50;50') einfallende elektromagnetische Wellen in Richtung des Durchgangs (5; 50;50') zu reflektieren;
wobei das zweite Reflektorelement (R2; 46; 48') über eine galvanische Verbindung (49') mit dem zweiten Abschnitt (21'-2) der zweiten leitenden Schicht (20) verbunden ist; und
wobei an dem ersten Abschnitt (21) der zweiten leitenden Schicht (20) das Hochfrequenzsignal (9) abgreifbar ist.

3. Vorrichtung nach einem der Ansprüche 1 oder 2, mit einem zweiten Verschlusselement (40; 40'), welches an der zweiten Oberfläche (A2; 12-2) des Trägers (4; 4'; 12) über dem Durchgang (5; 50; 50') angeordnet ist und welches eine zweite metallische Schicht (48; 48') aufweist, welche dem Durchgang (5; 50; 50') zugewandt ist.

4. Vorrichtung nach Ansprüchen 2 und 3,
wobei das erste Reflektorelement (36) als eine an einer von dem Träger (4; 4') abgewandten Oberfläche (34-a) des ersten Verschlusselements (30) angebrachte dritte metallische Schicht (36) ausgebildet ist; und/oder wobei das zweite Reflektorelement (46) als eine an einer von dem Träger (4; 4') abgewandten Oberfläche (44-a) des zweiten Verschlusselements (40) angebrachte vierte metallische Schicht (46) ausgebildet ist.

5. Vorrichtung nach Anspruch 3 oder 4, wobei das Empfangselement (42) ein Teil der zweiten metallischen Schicht (48) ausgebildet ist.

6. Vorrichtung nach einem der vorangehenden Ansprüche 1 bis 5, wobei an der
ersten Oberfläche (12-1) des Trägers (12) eine erste nichtleitende Schicht (14') ausgebildet ist, welche den Durchgang (50') an der ersten Oberfläche (12-1) verschließt; und
wobei an der zweiten Oberfläche (12-2) des Trägers (12) eine zweite nichtleitende Schicht (16') ausgebildet ist, welche den Durchgang (50') an der zweiten Oberfläche (12-2) verschließt.

7. Vorrichtung nach Anspruch 6, wobei das Empfangselement (21'-3) an der zweiten nichtleitenden Schicht (16') angeordnet ist.

8. Vorrichtung nach einem der vorangehenden Ansprüche 1 bis 7, mit mindestens einem Antennenelement (6), welches an oder auf der zweiten Oberfläche (A2; 12-2) des Trägers (4; 4'; 12) angeordnet ist; und welches mit dem Empfangselement (3; 42; 21'-3) zum Übertragen des Hochfrequenzsignals (9) von dem Empfangselement (3; 42; 21'-3) an das Antennenelement (6) galvanisch oder elektromagnetisch verbunden ist.

9. Vorrichtung nach einem der vorangehenden Ansprüche 1 bis 8,
mit einer Hochfrequenzsignal-Erzeugungseinrichtung (60) zum Erzeugen des Hochfrequenzsignals (9), welche an oder auf der ersten Oberfläche (A1; 12-1) des Trägers (4; 4'; 12) angeordnet ist und welche zum Übertragen des Hochfrequenzsignals (9) von der Hochfrequenzsignal-Erzeugungseinrichtung (60) an das Sendeelement (2; 32) mit dem Sendeelement (2; 32) galvanisch oder elektromagnetisch verbunden ist.

10. Verfahren zum Übertragen eines Hochfrequenzsignals mit den Schritten:
Bereitstellen (S01) eines Hochfrequenzsignals (9);
Übertragen (S02) des Hochfrequenzsignals (9) über eine galvanische oder
elektromagnetische Verbindung (62, 19, 33, 38-1; 62, 19'-1), umfassend einen ersten Abschnitt (19,19'-1) einer ersten leitenden Schicht (18), an ein Sendeelement (2; 32), welches an einer ersten Oberfläche (A1; 12-1) eines elektrisch nichtleitenden Trägers (4; 4'; 12) ausgebildet ist, wobei eine erste leitende Schicht (18) auf der ersten Oberfläche (A1; 12-1) des Trägers (4; 4'; 12) ausgebildet ist und einen ersten Abschnitt (19, 19'-1) und einen zweiten Abschnitt (19'-2) aufweist, welche galvanisch voneinander getrennt sind; Übertragen (S03) des Hochfrequenzsignals (9) durch einen Durchgang (5; 50; 50'), welcher von der ersten Oberfläche (A1; 12-1) des Trägers (4; 4'; 12) zu einer zweiten Oberfläche (A2; 12-2) des Trägers (4; 4'; 12) ausgebildet ist, als elektromagnetische Welle (9') an ein Empfangselement (3; 42; 21'-3), welches an oder auf der zweiten Oberfläche (A2; 12-2) des Trägers (4; 4'; 12) ausgebildet ist; und Reflektieren aus der Richtung des Durchgangs (5; 50;50') einfallender elektromagnetischer Wellen in Richtung des Durchgangs (5; 50;50') mittels eines ersten Reflektorelements (R1; 36), wobei das Sendeelement (2; 32) zwischen dem Träger (4; 4'; 12) und dem ersten Reflektorelement (R1; 36) angeordnet ist, wobei ein erstes Verschlusselement (30) das erste Reflektorelement (R1; 36) umfasst, und wobei das erste Verschlusselement (30) einen weiteren nicht-leitenden Träger (34) umfasst, wobei das erste Verschlusselement (30) auf einer dem Durchgang (5; 50;50') zugewandten Seite (34-i) des weiteren nicht-leitenden Trägers (34) eine strukturierte metallische Schicht (38) mit einem ersten Abschnitt (38-1) und einem zweiten Abschnitt(38-2) umfasst, und wobei der erste Abschnitt (38-1) der strukturierten metallischen Schicht (38) das Sendeelement (2; 32) umfasst und galvanisch über eine erste galvanische Verbindung (33) mit dem ersten Abschnitt (19,19'-1) der ersten leitenden Schicht (18) verbunden ist, und der zweite Abschnitt (38-2) der strukturierten metallischen Schicht (38) über eine galvanische Verbindung (31') mit dem zweiten Abschnitt (19'-2) der ersten leitenden Schicht (18) verbunden ist.

11. Verfahren nach Anspruch 10 mit dem Schritt:
Reflektieren aus der Richtung des Durchgangs (5; 50;50') einfallender elektromagnetischer Wellen in Richtung des Durchgangs (5; 50;50') mittels eines zweiten Reflektorelements (R2; 46; 48'), wobei das Empfangselement (3; 42; 21'-3) zwischen dem Träger (4; 4'; 12) und dem zweiten Reflektorelement (R2; 46; 48') angeordnet ist.

12. Verfahren nach Anspruch 10 oder 11, mit den Schritten:
Übertragen (S05) des an das Empfangselement (3; 42; 19) übertragenen Hochfrequenzsignals (9) über eine galvanische oder elektromagnetische Verbindung (48-1, 43, 21, 7, 8; 21'-1, 7, 8) an mindestens ein Antennenelement (6); und
Aussenden (S06) einer elektromagnetischen Welle durch das mindestens eine Antennenelement (6), basierend auf dem an das mindestens eine Antennenelement (6) übertragenen Hochfrequenzsignal (9).

## Claims

1. Apparatus for transmitting a high-frequency signal, comprising:
an electrically non-conductive carrier (4; 4'; 12) through which a passage (5; 50; 50') from a first surface (A1; 12-1) of the carrier (4; 4'; 12) to a second surface (A2; 12-2) of the carrier (4; 4'; 12) is formed;
a first conductive layer (18) which is formed on the first surface (A1; 12-1) of the carrier (4; 4'; 12) and
has a first section (19; 19'-1) and a second section (19'-2) which are galvanically isolated from one another;
a first closure element (30) having a first reflector element (R1; 36) which is designed to reflect electromagnetic waves incident from the direction of the passage (5; 50; 50') in the direction of the passage (5; 50; 50');
a transmitting element (2; 32) which is located on the first surface (A1; 12-1) of the carrier (4; 4'; 12) between the carrier (4; 4'; 12) and the first reflector element (R1; 36) and to which the high-frequency signal (9) can be applied via the first section (19; 19'-1) of the first conductive layer (18); and
a receiving element (3; 42; 21'-3) which is located upon or on the second surface (A2; 12-2) of the carrier (4; 4'; 12) and which is galvanically isolated from the transmitting element (2; 32);
wherein the first closure element (30) comprises a further non-conductive carrier (34), and wherein the first closure element (30), on a side (34-i) of the further non-conductive carrier (34) that faces the passage (5; 50; 50'), comprises a structured metal layer (38) with a first section (38-1) and a second section (38-2),
wherein the first section (38-1) of the structured metal layer (38) comprises the transmitting element (2; 32) and is galvanically connected to the first section (19, 19'-1) of the first conductive layer (18) via a first galvanic connection (33), and the second section (38-2) of the structured metal layer (38) is connected to the second section (19'-2) of the first conductive layer (18) via a galvanic connection (31'); and
wherein the applied high-frequency signal (9) can be transmitted through the passage (5; 50; 50') through the carrier (4; 4'; 12) as an electromagnetic wave (9') to the receiving element (3; 42; 21'-3) by means of the transmitting element (2; 32).

2. Apparatus according to Claim 1,
comprising a second conductive layer (20) which is formed upon the second surface (A2; 12-2) and has a first section (21) and a second section which are galvanically isolated from one another;
wherein the receiving element (3; 42; 21'-3) is arranged between the carrier (4; 4'; 12) and a second reflector element (R2; 46; 48') which is designed to reflect electromagnetic waves incident from the direction of the passage (5; 50; 50') in the direction of the passage (5; 50; 50');
wherein the second reflector element (R2; 46; 48') is connected to the second section (21'-2) of the second conductive layer (20) via a galvanic connection (49'); and
wherein the high-frequency signal (9) can be tapped off from the first section (21) of the second conductive layer (20).

3. Apparatus according to either of Claims 1 and 2, comprising a second closure element (40; 40') which is arranged on the second surface (A2; 12-2) of the carrier (4; 4'; 12) above the passage (5; 50; 50') and which has a second metal layer (48; 48') which faces the passage (5; 50; 50').

4. Apparatus according to Claims 2 and 3,
wherein the first reflector element (36) is designed as a third metal layer (36) which is placed on a surface (34-a) of the first closure element (30) that faces away from the carrier (4; 4'); and/or
wherein the second reflector element (46) is designed as a fourth metal layer (46) which is placed on a surface (44-a) of the second closure element (40) that faces away from the carrier (4; 4').

5. Apparatus according to Claim 3 or 4,
wherein the receiving element (42) is formed a part of the second metal layer (48).

6. Apparatus according to one of preceding Claims 1 to 5,
wherein a first non-conductive layer (14') is formed on the first surface (12-1) of the carrier (12) and closes the passage (50') on the first surface (12-1); and
wherein a second non-conductive layer (16') is formed on the second surface (12-2) of the carrier (12) and closes the passage (50') on the second surface (12-2).

7. Apparatus according to Claim 6,
wherein the receiving element (21'-3) is arranged on the second non-conductive layer (16').

8. Apparatus according to one of preceding Claims 1 to 7,
comprising at least one antenna element (16) which is arranged on or upon the second surface (A2; 12-2) of the carrier (4; 4'; 12); and which is galvanically or electromagnetically connected to the receiving element (3; 42; 21'-3) for transmitting the high-frequency signal (9) from the receiving element (3; 42; 21'-3) to the antenna element (6).

9. Apparatus according to one of preceding Claims 1 to 8,
comprising a high-frequency signal generating device (60) for generating the high-frequency signal (9), which device is arranged on or upon the first surface (A1; 12-1) of the carrier (4; 4'; 12) and is galvanically or electromagnetically connected to the transmitting element (2; 32) for transmitting the high-frequency signal (9) from the high-frequency signal generating device (60) to the transmitting element (2; 32).

10. Method for transmitting a high-frequency signal, comprising the steps of:
providing (S01) a high-frequency signal (9);
transmitting (S02) the high-frequency signal (9) via a galvanic or electromagnetic connection (62, 19, 33, 38-1; 62, 19'-1), comprising a first section (19, 19'-1) of a first conductive layer (18), to a transmitting element (2; 32) which is formed on a first surface (A1; 12-1) of an electrically non-conductive carrier (4; 4'; 12), wherein a first conductive layer (18) is formed on the first surface (A1; 12-1) of the carrier (4; 4'; 12) and has a first section (19, 19'-1) and a second section (19'-2) which are galvanically isolated from one another; transmitting (S03) the high-frequency signal (9) through a passage (5; 50; 50'), which is formed from the first surface (A1; 12-1) of the carrier (4; 4'; 12) to a second surface (A2; 12-2) of the carrier (4; 4'; 12), as an electromagnetic wave (9') to a receiving element (3; 42; 21'-3) which is formed on or upon the second surface (A2; 12-2) of the carrier (4; 4'; 12); and
reflecting electromagnetic waves incident from the direction of the passage (5; 50; 50') in the direction of the passage (5; 50; 50') by means of a first reflector element (R1; 36), wherein the transmitting element (2; 32) is arranged between the carrier (4; 4'; 12) and the first reflector element (R1; 36), wherein a first closure element (30) comprises the first reflector element (R1; 36), and wherein the first closure element (30) comprises a further non-conductive carrier (34), wherein the first closure element (30), on a side (34-i) of the further non-conductive carrier (34) that faces the passage (5; 50; 50'), comprises a structured metal layer (38) with a first section (38-1) and a second section (38-2), and wherein the first section (38-1) of the structured metal layer (38) comprises the transmitting element (2; 32) and is galvanically connected to the first section (19, 19'-1) of the first conductive layer (18) via a first galvanic connection (33), and the second section (38-2) of the structured metal layer (38) is connected to the second section (19'-2) of the first conductive layer (18) via a galvanic connection (31').

11. Method according to Claim 10, comprising the step of:
reflecting electromagnetic waves incident from the direction of the passage (5; 50; 50') in the direction of the passage (5; 50; 50') by means of a second reflector element (R2; 46; 48'), wherein the receiving element (3; 42; 21'-3) is arranged between the carrier (4; 4'; 12) and the second reflector element (R2; 46; 48').

12. Method according to Claim 10 or 11, comprising the steps of:
transmitting (S05) the high-frequency signal (9), which is transmitted to the receiving element (3; 42; 19), to at least one antenna element (6) via a galvanic or electromagnetic connection (48-1, 43, 21, 7, 8; 21'-1, 7, 8); and
emitting (S06) an electromagnetic wave through the at least one antenna element (6), based on the high-frequency signal (9) which is transmitted to the at least one antenna element (6).

## Revendications

1. Dispositif de transmission d'un signal haute fréquence, comprenant :
un support non conducteur électriquement (4 ; 4' ; 12) à travers lequel un passage (5 ; 50 ; 50') d'une première surface (A1 ; 12-1) du support (4 ; 4' ; 12) à une deuxième surface (A2 ; 12-2) du support (4 ; 4' ; 12) est réalisé ;
une première couche conductrice (18) qui est réalisée sur la première surface (A1 ; 12-1) du support (4 ; 4' ; 12) et présente une première partie (19, 19'-1) et une deuxième partie (19'-2) qui sont isolées galvaniquement l'une de l'autre ;
un premier élément de fermeture (30) doté d'un premier élément réflecteur (R1 ; 36) qui est conçu pour réfléchir des ondes électromagnétiques incidentes depuis la direction du passage (5 ; 50 ; 50') en direction du passage (5 ; 50 ; 50') ;
un élément émetteur (2 ; 32) qui est disposé sur la première surface (A1 ; 12-1) du support (4 ; 4' ; 12) entre le support (4 ; 4' ; 12) et le premier élément réflecteur (R1 ; 36) et auquel le signal haute fréquence (9) peut être appliqué par l'intermédiaire de la première partie (19, 19'-1) de la première couche conductrice (18) ; et
un élément récepteur (3 ; 42 ; 21'-3) qui est disposé sur ou au niveau de la deuxième surface (A2 ; 12-2) du support (4 ; 4' ; 12) et qui est isolé galvaniquement de l'élément émetteur (2 ; 32) ;
le premier élément de fermeture (30) comprenant un autre support non conducteur (34), et le premier élément de fermeture (30) comprenant sur un côté (34-i), tourné vers le passage (5 ; 50 ; 50'), de l'autre support non conducteur (34) une couche métallique structurée (38) dotée d'une première partie (38-1) et d'une deuxième partie (38-2),
la première partie (38-1) de la couche métallique structurée (38) comprenant l'élément émetteur (2 ; 32), et étant reliée galvaniquement par l'intermédiaire d'une première liaison galvanique (33) à la première partie (19, 19'-1) de la première couche conductrice (18), et la deuxième partie (38-2) de la couche métallique structurée (38) étant reliée par l'intermédiaire d'une liaison galvanique (31') à la deuxième partie (19'-2) de la première couche conductrice (18) ; et
dans lequel, au moyen de l'élément émetteur (2 ; 32), le signal haute fréquence (9) appliqué peut être transmis par le passage (5 ; 50 ; 50') à travers le support (4 ; 4' ; 12) sous forme d'onde électromagnétique (9') à l'élément récepteur (3 ; 42 ; 21'-3) .

2. Dispositif selon la revendication 1, comprenant une deuxième couche conductrice (20) qui est réalisée sur la deuxième surface (A2 ; 12-2) et présente une première partie (21) et une deuxième partie qui sont isolées galvaniquement l'une de l'autre ;
l'élément récepteur (3 ; 42 ; 21'-3) étant disposé entre le support (4 ; 4' ; 12) et un deuxième élément réflecteur (R2 ; 46 ; 48') qui est conçu pour réfléchir des ondes électromagnétiques incidentes depuis la direction du passage (5 ; 50 ; 50') en direction du passage (5 ; 50 ; 50') ;
le deuxième élément réflecteur (R2 ; 46 ; 48') étant relié par l'intermédiaire d'une liaison galvanique (49') à la deuxième partie (21'-2) de la deuxième couche conductrice (20) ; et
le signal haute fréquence (9) pouvant être prélevé au niveau de la première partie (21) de la deuxième couche conductrice (20).

3. Dispositif selon l'une quelconque des revendications 1 et 2, comprenant un deuxième élément de fermeture (40 ; 40') qui est disposé sur la deuxième surface (A2 ; 12-2) du support (4 ; 4' ; 12) au-dessus du passage (5 ; 50 ; 50') et qui présente une deuxième couche métallique (48 ; 48') qui est tournée vers le passage (5 ; 50 ; 50').

4. Dispositif selon les revendications 2 et 3,
le premier élément réflecteur (36) étant réalisé sous la forme d'une troisième couche métallique (36) fixée à une surface (34-a), détournée du support (4 ; 4'), du premier élément de fermeture (30) ; et/ou le deuxième élément réflecteur (46) étant réalisé sous la forme d'une quatrième couche métallique (46) fixée à une surface (44-a), détournée du support (4 ; 4'), du deuxième élément de fermeture (40).

5. Dispositif selon la revendication 3 ou 4, dans lequel l'élément récepteur (42) est réalisé une partie de la deuxième couche métallique (48).

6. Dispositif selon l'une quelconque des revendications précédentes 1 à 5, dans lequel
sur la première surface (12-1) du support (12), une première couche non conductrice (14') est réalisée qui ferme le passage (50') au niveau de la première surface (12-1) ; et
sur la deuxième surface (12-2) du support (12), une deuxième couche non conductrice (16') est réalisée qui ferme le passage (50') au niveau de la deuxième surface (12-2).

7. Dispositif selon la revendication 6, dans lequel l'élément récepteur (21'-3) est disposé au niveau de la deuxième couche non conductrice (16').

8. Dispositif selon l'une quelconque des revendications précédentes 1 à 7, comprenant au moins un élément d'antenne (6) qui est disposé au niveau de ou sur la deuxième surface (A2 ; 12-2) du support (4 ; 4' ; 12) ; et qui est relié de manière galvanique ou électromagnétique à l'élément récepteur (3 ; 42 ; 21'-3) pour transmettre le signal haute fréquence (9) de l'élément récepteur (3 ; 42 ; 21'-3) à l'élément d'antenne (6).

9. Dispositif selon l'une quelconque des revendications précédentes 1 à 8, comprenant un dispositif de génération de signaux haute fréquence (60) pour générer le signal haute fréquence (9) qui est disposé au niveau de ou sur la première surface (A1 ; 12-1) du support (4 ; 4' ; 12) et qui est relié de manière galvanique ou électromagnétique à l'élément émetteur (2 ; 32) pour transmettre le signal haute fréquence (9) du dispositif de génération de signaux haute fréquence (60) à l'élément émetteur (2 ; 32).

10. Procédé de transmission d'un signal haute fréquence, comprenant les étapes consistant à :
fournir (S01) un signal haute fréquence (9) ;
transmettre (S02) le signal haute fréquence (9) par l'intermédiaire d'une liaison galvanique ou électromagnétique (62, 19, 33, 38-1 ; 62, 19'-1), comprenant une première partie (19, 19'-1) d'une première couche conductrice (18), à un élément émetteur (2 ; 32) qui est réalisé au niveau d'une première surface (A1 ; 12-1) d'un support non conducteur électriquement (4 ; 4' ; 12), une première couche conductrice (18) étant réalisée sur la première surface (A1 ; 12-1) du support (4 ; 4' ; 12) et présentant une première partie (19, 19'-1) et une deuxième partie (19'-2) qui sont isolées galvaniquement l'une de l'autre ;
transmettre (S03) le signal haute fréquence (9) par un passage (5 ; 50 ; 50'), qui est réalisé de la première surface (A1 ; 12-1) du support (4 ; 4' ; 12) à une deuxième surface (A2 ; 12-2) du support (4 ; 4' ; 12), sous la forme d'une onde électromagnétique (9') à un élément récepteur (3 ; 42 ; 21'-3) qui est réalisé au niveau de ou sur la deuxième surface (A2 ; 12-2) du support (4 ; 4' ; 12) ; et
réfléchir des ondes électromagnétiques incidentes depuis la direction du passage (5 ; 50 ; 50') en direction du passage (5 ; 50 ; 50') au moyen d'un premier élément réflecteur (R1 ; 36), l'élément émetteur (2 ; 32) étant disposé entre le support (4 ; 4' ; 12) et le premier élément réflecteur (R1 ; 36), un premier élément de fermeture (30) comprenant le premier élément réflecteur (R1 ; 36), et le premier élément de fermeture (30) comprenant un autre support non conducteur (34), le premier élément de fermeture (30) comprenant sur un côté (34-i), tourné vers le passage (5 ; 50 ; 50'), de l'autre support non conducteur (34), une couche métallique structurée (38) dotée d'une première partie (38-1) et d'une deuxième partie(38-2), et la première partie (38-1) de la couche métallique structurée (38) comprenant l'élément émetteur (2 ; 32) et étant reliée de manière galvanique par l'intermédiaire d'une première liaison galvanique (33) à la première partie (19, 19'-1) de la première couche conductrice (18), et la deuxième partie (38-2) de la couche métallique structurée (38) étant reliée par l'intermédiaire d'une liaison galvanique (31') à la deuxième partie (19'-2) de la première couche conductrice (18).

11. Procédé selon la revendication 10, comprenant l'étape consistant à :
réfléchir des ondes électromagnétiques incidentes depuis la direction du passage (5 ; 50 ; 50') en direction du passage (5 ; 50 ; 50') au moyen d'un deuxième élément réflecteur (R2 ; 46 ; 48'), l'élément récepteur (3 ; 42 ; 21'-3) étant disposé entre le support (4 ; 4' ; 12) et le deuxième élément réflecteur (R2 ; 46 ; 48').

12. Procédé selon la revendication 10 ou 11, comprenant les étapes consistant à :
transmettre (S05) le signal haute fréquence (9) transmis à l'élément récepteur (3 ; 42 ; 19) par l'intermédiaire d'une liaison galvanique ou électromagnétique (48-1, 43, 21, 7, 8 ; 21'-1, 7, 8) à au moins un élément d'antenne (6) ; et
émettre (S06) une onde électromagnétique par ledit au moins un élément d'antenne (6), sur la base du signal haute fréquence (9) transmis audit au moins un élément d'antenne (6).
